# EUROPEAN PATENT SPECIFICATION

(11) **EP 2 806 466 B1**
(45) Date of publication and mention of the grant of the patent: **14.09.2016**
(21) Application number: 14168884.6
(22) Date of filing: 19.05.2014
(51) Int. Cl.: H01L 31/0224, H01L 31/18

(54) **Transparent conductive film manufacturing method, apparatus thereof, and transparent conductive film thereof**
Herstellungsverfahren für transparente leitfähige Schicht, Vorrichtung dafür und transparente leitfähige Schicht daraus
Procédé de fabrication de film conducteur transparent, appareil associé et film conducteur transparent ainsi produit

(30) Priority: 21.05.2013 KR 20130057253
(43) Date of publication of application: 26.11.2014
(73) Proprietor: Korea Institute Of Machinery & Materials, Yuseong-gu Daejeon 305-343 (KR)
(72) Inventor: Jo, Jeongdai, Daejeon 305-343 (KR); Kim, Kwang-Young, Daejeon 305-343 (KR); Choi, Young Man, Daejeon 305-343 (KR); Jang, Yunseok, Daejeon 305-343 (KR)
(74) Representative: Delorme, Nicolas

(56) References cited:
- JP-A- 2008 028 164
- JP-A- 2012 022 833
- US-A1- 2010 021 695
- GRANQVIST C G ED - ESCOUBAS LUDOVIC ET AL: "Transparent conductors as solar energy materials: A panoramic review", SOLAR ENERGY MATERIALS AND SOLAR CELLS, ELSEVIER SCIENCE PUBLISHERS, AMSTERDAM, NL, vol. 91, 1 January 2007 (2007-01-01), pages 1529-1598, XP002506674, ISSN: 0927-0248, DOI: 10.1016/J.SOLMAT.2007.04.031

## Description

### BACKGROUND OF THE INVENTION

### (a) Field of the Invention

The present invention relates to a transparent conductive film manufacturing method which forms a minute conductive pattern on a transparent substrate, an apparatus thereof, and a transparent conductive film thereof. Document JP2008028164 A is a closely related prior art.

### (b) Description of the Related Art

Generally, a minute pattern is formed on a transparent substrate and the minute pattern is filled with a metal paste to form a transparent conductive film For example, a concave pattern groove of the minute pattern is formed in a synthetic resin film and the pattern groove is filled with the metal paste to form a transparent electrode.

The metal paste which is filled and smeared outside the pattern groove is removed by using a blade. A blade process using a blade is included so that a process of manufacturing a transparent electrode becomes complicated.

The above information disclosed in this Background section is only for enhancement of understanding of the background of the invention and therefore it may contain information that does not form the prior art that is already known in this country to a person of ordinary skill in the art.

### SUMMARY OF THE INVENTION

The present invention has been made in an effort to provide a transparent conductive film manufacturing method which easily fills a metal paste in a pattern groove and simplifies the process. The present invention has also been made in an effort to provide an apparatus which implements the transparent conductive film manufacturing method. The present invention has also been made in an effort to provide a transparent conductive film manufactured by the transparent conductive film manufacturing method and the apparatus thereof.

An exemplary embodiment of the present invention provides a transparent conductive film manufacturing method in a first step of processing one surface of a transparent film with plasma to form a hydrophobic surface with minute nano-metric protrusions and grooves; a second step of patterning a hydrophilic pattern groove on one surface of the transparent film; a third step of dispensing a conductive paste onto the pattern groove of the transparent film; and a fourth step of drying and hardening the conductive paste.

The second step may pattern the pattern groove using a laser head by a scribing method.

The third step may dispense the conductive paste to the pattern groove using a dispenser by a drop method.

The second step may pattern the pattern groove using a roll imprinter by an imprinting method.

Another exemplary embodiment of the present invention provides a transparent conductive film manufacturing apparatus including: an unwinder which supplies a transparent film; a plasma processing unit which processes one surface of the transparent film which is supplied by the unwinder with plasma to form a hydrophobic surface with minute nano-metric protrusions and grooves; a patterning unit which patterns a hydrophilic pattern groove on one surface of the transparent film which passes through the plasma processing unit; a dispensing unit which dispenses the conductive paste to the pattern groove of the transparent film which passes through the patterning unit; a drying unit which dries and hardens the conductive paste on the transparent film which passes through the dispensing unit; and a winder which winds the transparent conductive film which is manufactured by passing through the drying unit.

The patterning unit may be formed as a laser head or a roll imprinter.

Another exemplary embodiment of the present invention provides a transparent conductive film, including: a transparent film which includes a hydrophobic part which is formed with minute nano-metric protrusions and grooves on one surface thereof by plasma processing and a hydrophilic part which is formed between the hydrophobic parts as a pattern groove; and a conductive part which is formed by a conductive paste which fills the pattern groove, wherein a lowest limit value of the line width of the conductive part is 0.6 µm.

The lowest limit value of the line width of the conductive part may be 5 µm.

The transparent film may be one of PI, PET, PEN, and PI, and the conductive paste may be one of Ag, Al, and a conductive polymer.

A difference in a height between an upper edge of the protrusion and a bottom of the groove may be 1 to 10 nm.

As described above, according to the exemplary embodiment of the present invention, plasma processing is performed on one surface of the transparent film to impart hydrophobicity thereto, and the pattern groove is patterned to partially impart hydrophilicity thereto to dispense the conductive paste to the hydrophilic pattern groove while preventing the conductive paste from remaining in a hydrophobic part to dry and harden the conductive paste. By doing this, the transparent conductive film is manufactured.

Therefore, the hydrophilic pattern groove which is enclosed by the hydrophobic part is easily filled with the metal paste and the metal paste is completely prevented from being applied in the hydrophobic part so that a blade process which removes the remaining metal paste is omitted, thereby simplifying the manufacturing process.

### BRIEF DESCRIPTION OF THE DRAWINGS

FIG. 1 is a flowchart of a transparent conductive film manufacturing method according to a first exemplary embodiment of the present invention.
FIG. 2 is a schematic diagram illustrating a transparent conductive film manufacturing apparatus which implements the manufacturing method of FIG. 1.
FIG. 3 is a flowchart of a transparent conductive film manufacturing method according to a second exemplary embodiment of the present invention.
FIG. 4 is a schematic diagram illustrating a transparent conductive film manufacturing apparatus which implements the manufacturing method of FIG. 3.
FIGS. 5 to 10 are top plan views of a transparent conductive film manufactured according to the first and second exemplary embodiments.

### DETAILED DESCRIPTION OF THE EMBODIMENTS

Hereinafter, the present invention will be described more fully with reference to the accompanying drawings, in which exemplary embodiments of the invention are shown. The drawings and description are to be regarded as illustrative in nature and not restrictive. Like reference numerals designate like elements throughout the specification.

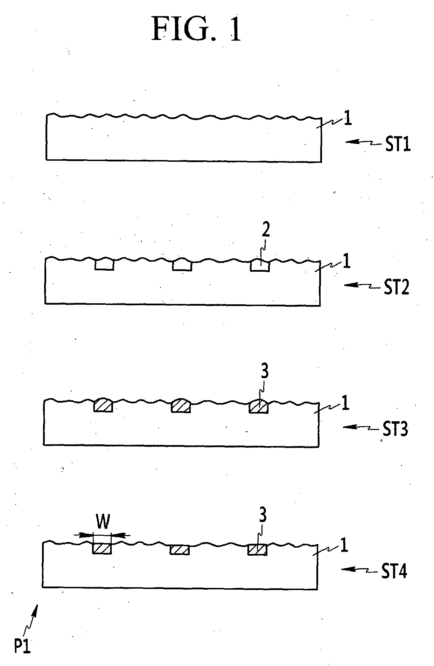

FIG. 1 is a flowchart of a transparent conductive film manufacturing method according to a first exemplary embodiment of the present invention. Referring to FIG. 1, a transparent conductive film manufacturing method according to a first exemplary embodiment includes a first step ST1 of processing a transparent film 1 with plasma, a second step ST2 of patterning a pattern groove 2, a third step ST3 of dispensing a conductive paste 3, and a fourth step ST4 of drying and hardening the dispensed conductive paste.

Hereinafter, specific steps of the transparent conductive film manufacturing method will be explained while describing a transparent conductive film manufacturing apparatus 100 according to a first exemplary embodiment.

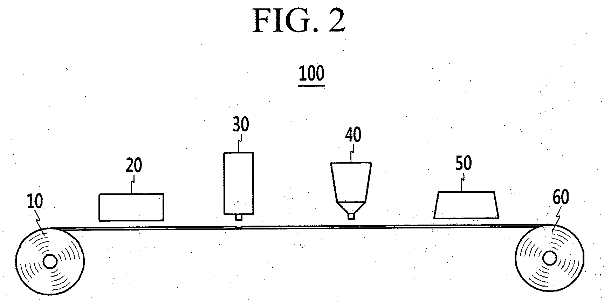

FIG. 2 is a schematic diagram illustrating a transparent conductive film manufacturing apparatus which implements the manufacturing method of FIG. 1. Referring to FIG. 2, the transparent conductive film manufacturing apparatus 100 according to the first exemplary embodiment includes an unwinder 10, a plasma processing unit 20, a patterning unit 30, a dispensing unit 40, a drying unit 50, and a winder 60.

In the first step ST1, plasma processing is performed on one surface of the transparent film 1 using the plasma processing unit 20 to form minute protrusions and grooves on the one surface of the transparent film 1. The minute protrusions and grooves impart hydrophobicity to the one surface of the transparent film 1. The plasma processing unit 20 may be configured as various types so as to perform plasma processing on the one surface of the transparent film 1 which is supplied to the unwinder 10.

The first step ST1 includes a process of supplying the transparent film 1 in the unwinder 10. In order to perform the plasma processing, the unwinder 10 supplies the transparent film 1 to the plasma processing unit 20.

For example, the transparent film 1 may be formed of polyimide (PI), polyethylene terephthalate (PET), polyethylene naphthalate (PEN), or polycarbonate (PC), and may have various thicknesses depending on purposes. Further, when the transparent film 1 is processed with plasma at a predetermined intensity for 30 seconds to one minute, the transparent film 1 may have appropriate hydrophobicity. As the plasma processing is performed on a surface of the transparent film 1 for 30 seconds to one minute, a contact angle of 100 degrees or higher is formed with respect to a water droplet, so that the transparent film may have the hydrophobicity.

In contrast, when the plasma processing is performed on the transparent film 1 at the same intensity for 10 seconds or shorter, the protrusions and the grooves are insufficiently formed so that the transparent film 1 may not have required hydrophobicity. Further, when the plasma processing is performed on the transparent film 1 at the same intensity for three minutes or longer, the protrusions and the grooves which are formed on the surface of the transparent film 1 are removed so that the transparent film 1 may not have required hydrophobicity.

The plasma processing unit 20 forms the minute protrusions and grooves on the surface of the transparent film 10 using a fluorine-based gas, for example, CF₄, HF, NF₃, or OF₂ to impart the hydrophobicity.

For example, when the plasma processing unit 20 performs the plasma processing using CF₄ gas, a difference in a height between an upper edge of the minute protrusion and a bottom of the groove, which are formed on the surface of the transparent film 10, is 1 to 10 nm.

When the difference in depth is 1 nm or less, it is hard to process the surface of the transparent film 10, and when the difference in depth is 10 nm or more, the surface of the transparent film 10 may have hydrophilicity. The difference in depth of the upper edge of the minute protrusion and the bottom of the groove may impart the hydrophobicity to the surface of the transparent film 10 in different ranges depending on the gas that is used for the plasma processing.

The second step ST2 patterns the pattern groove 2 on one surface of the transparent film 1 using the patterning unit 30. The pattern groove 2 has relative hydrophilicity as compared with other hydrophobic portions of the transparent film 1.

For example, the patterning unit 30 may be formed by a laser head, and the second step ST2 may pattern the pattern groove 2 using the laser head by a scribing method.

The patterning unit 30 may be formed as various types so as to pattern the pattern groove 2 on one surface of the transparent film 1 which passes through the plasma processing unit 20.

For example, the pattern groove 2 is formed on the surface of the transparent film 1 having hydrophobicity so that the one surface of the transparent film 1 is divided into a hydrophobic part and a hydrophilic part having hydrophilicity. That is, the hydrophobic part is formed on the one surface of the transparent film 1 by the plasma processing as the minute protrusions and grooves, and the hydrophilic part is formed between the hydrophobic parts as the pattern groove 2.

For example, the pattern groove 2 may be formed to have a rectangular shape on a cross-section of the transparent film 1. The pattern groove 2 on the rectangle cross-section increases an amount of conductive paste 3 to fill to improve the conductivity in the transparent conductive film P1.

In the third step ST3, the dispensing unit 40 dispenses the conductive paste 3 to the pattern groove 2 of the transparent film 1. In spite of the non-conductivity of the transparent film 1, the conductive paste 3 imparts the conductivity to a transparent conductive film P1.

For example, the dispensing unit 40 may be formed as a paste dispenser, and in the third step ST3, the dispenser dispenses the conductive paste 3 to the pattern groove 2 by a drop method.

The dispensing unit 40 is formed to dispense the conductive paste 3 to the pattern groove 2 of the transparent film 1 which passes through the patterning unit 30.

For example the conductive paste 3 may be formed of Ag, Al, or a conductive polymer. The conductive paste 3 may fill the pattern groove 2 to form a rectangular conductive part on the cross-section of the transparent conductive film P1.

Further, the transparent film 1 may form a transparent part in the transparent conductive film P1. Accordingly, the transparent conductive film may be used as a transparent electrode of a display device.

According to the first exemplary embodiment, the conductive part formed by the conductive paste 3 has a line width corresponding to a line width W of the pattern groove 3 so that the conductive part has excellent conductivity.

The conductive paste 3 which is dispensed by a drop method fills only the pattern groove 2 which forms the hydrophilic part to be convex and then is dried and hardened to increase the density of the conductive part, but is not provided at the outside of the pattern groove which forms the hydrophilic part.

Due to the hydrophobic part which is set at the outside of the pattern groove 2, there is no need to remove the conductive paste which is present at the outside of the pattern groove 2 using the blade, as in the process of the related art. That is, the third step ST3 omits the blading process of the related art.

In the fourth step ST4, the drying unit 50 dries and hardens the conductive paste 3. The transparent film 1 which forms the transparent part of the transparent conductive film P1 has heat resistance so as to not be deformed during the drying process.

For example, the drying unit 50 may be formed as an infrared dryer, and in the fourth step ST4, the dryer hardens and dries the conductive paste 3 which is dispensed to the pattern groove 2 by an infrared drying method.

The drying unit 50 is formed to dry and harden the conductive paste 3 on the transparent film 1 which passes through the dispensing unit 40. The dried conductive paste 3 is hardened only in the pattern groove 2 which forms the hydrophilic part to be flat or concave. Accordingly, the transparent conductive film P1 is completely formed.

The fourth step ST4 includes a process of winding the dried and hardened transparent film 1. That is, the winder 60 winds the manufactured transparent conductive film P1.

In the completed transparent conductive film P1, a lowest limit value of the line width W of the conductive part formed by the pattern groove 2 and the conductive paste 3 which fills the pattern groove 3 is 0.6 µm. When part has predetermined conductivity, the transparent conductive film P1 has excellent translucency when the line width W of the pattern groove 3 and the conductive part is smaller.

Accordingly, the pattern groove 2 needs to be formed as fine as possible so that a lowest limit value of the pattern groove 2 is meaningful. For example, the lowest limit value of the pattern groove 2 is 0.6 to 30 µm. When the line width W of the pattern groove 2 is too large, the translucency is lowered so that the transparent conductive film P1 may not fulfill its purpose.

Hereinafter, a second exemplary embodiment of the present invention will be described. The same configurations as those in the first exemplary embodiment will be omitted and different configurations will be described.

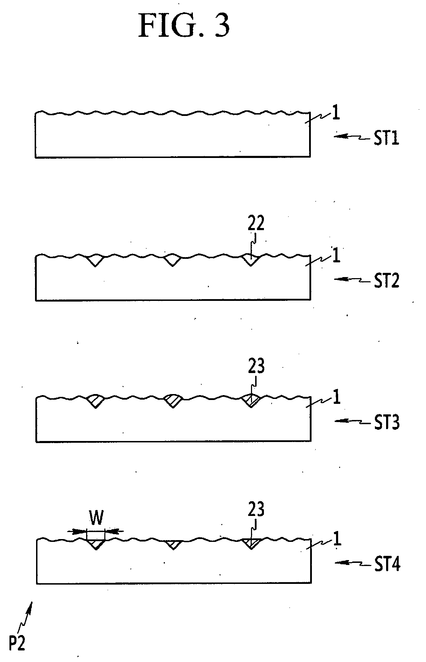

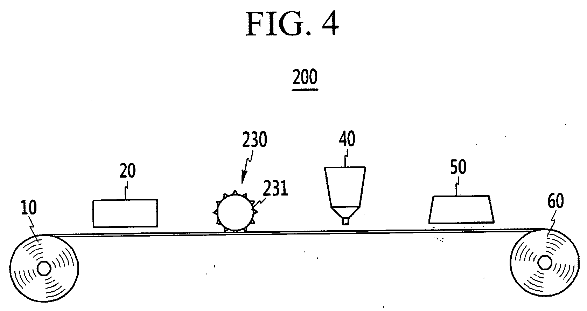

FIG. 3 is a flowchart of a transparent conductive film manufacturing method according to a second exemplary embodiment of the present invention, and FIG. 4 is a schematic diagram illustrating a transparent conductive film manufacturing apparatus 200 which implements the manufacturing method of FIG. 3. Referring to FIGS. 3 and 4, a patterning unit 230 includes a roll imprinter.

In a second step ST2, a pattern groove 22 is patterned on one surface of a transparent film 1 which is hydrophobically processed by an imprinting method of the roll imprinter as the plasma-processed transparent film 1 is supplied.

For example, the pattern groove 22 may be formed to have a triangular shape on a cross-section of the transparent film 1. The pattern groove 11 having a triangular cross-section may reduce an amount of consumed conductive paste 23 as compared with the rectangular cross-section having the same line width W, and allows the imprinting roll to be easily manufactured in the roll imprinter 231.

In a transparent conductive film P2, a lowest limit value of the line width W of the pattern groove 22 may be 5 µm. That is, the roll imprinter forms the pattern groove 22 to have a larger line width than a line width of a pattern groove formed by a laser head. For example, the lowest limit value of the pattern groove 22 is 5 to 30 µm.

The first and second exemplary embodiments exemplify the pattern grooves 2 and 22 which are formed to have a rectangular shape or a triangular shape on the cross-section of the transparent film 1. Even though not illustrated, the pattern groove may be formed to be a partial cross-section of a circle, a pentagon, or a hexagon.

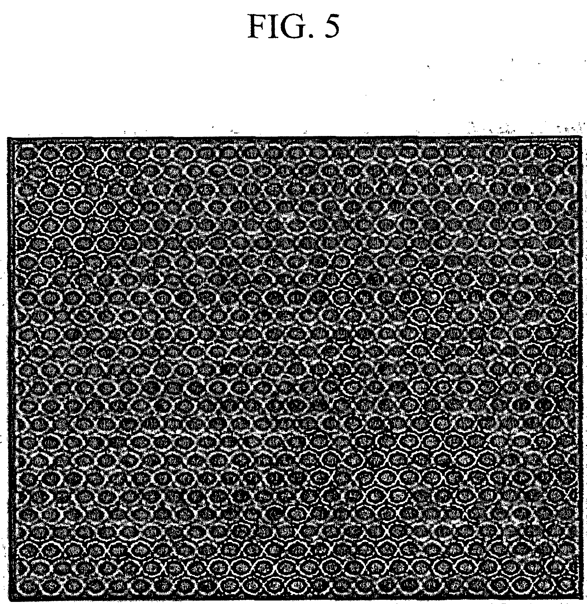

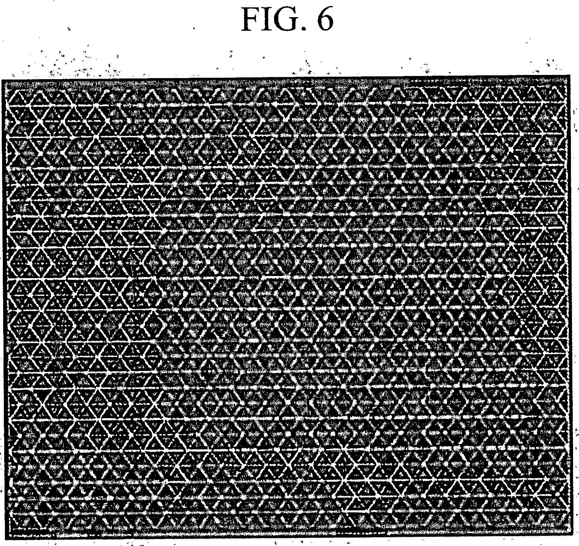

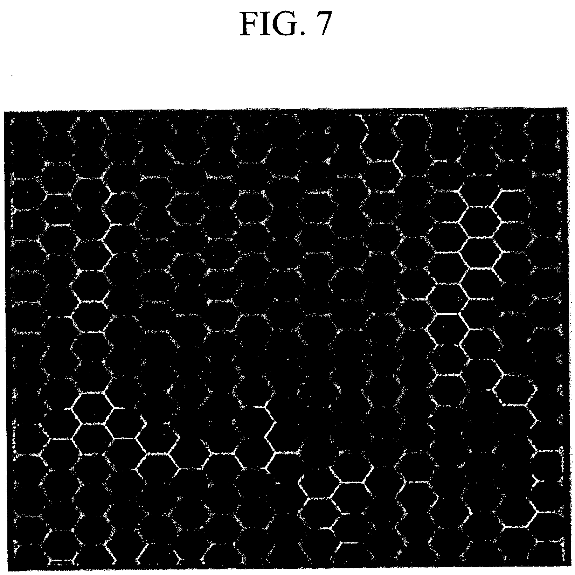

FIGS. 5 to 10 are top plan views of transparent conductive films manufactured according to the first and second exemplary embodiments. In FIGS. 5 to 10, a white portion indicates a conductive part of a pattern. Referring to FIG. 5, a transparent conductive film P3 includes a conductive part ²having a circular pattern. Referring to FIG. 6, a transparent conductive film P4 includes a conductive part having a triangular pattern. Referring to FIG. 7, a transparent conductive film P5 includes a conductive part having a honeycomb pattern.

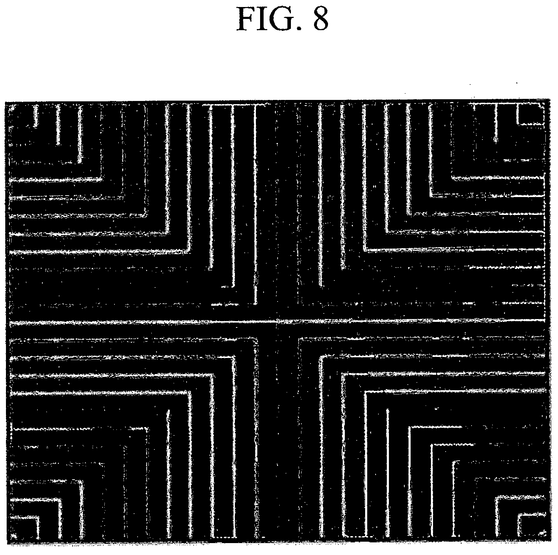

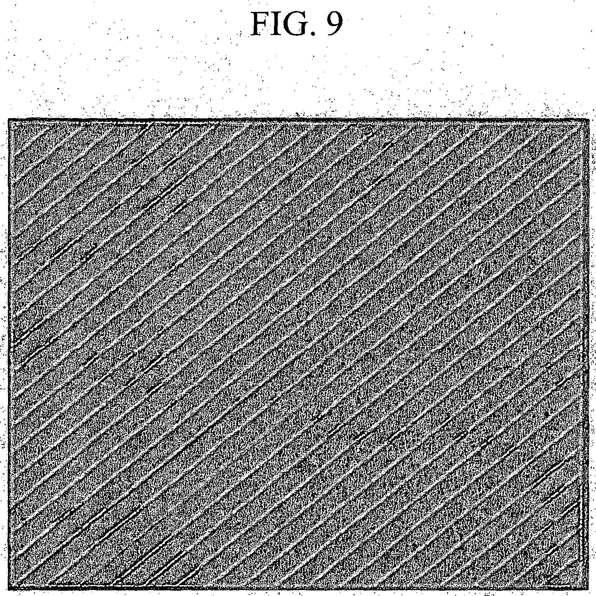

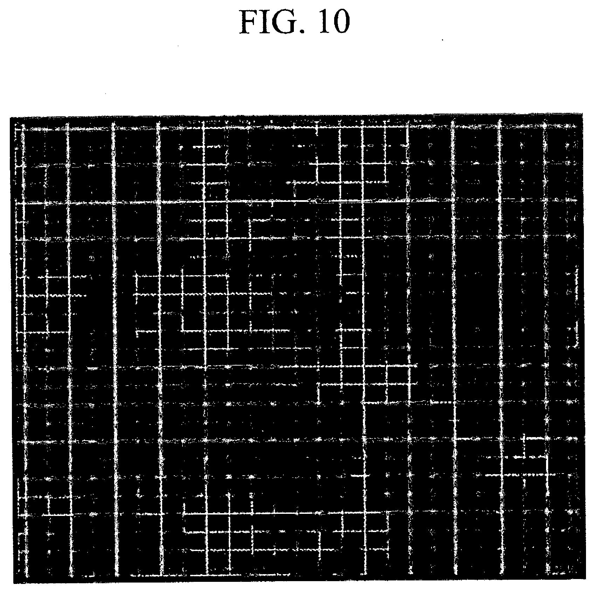

Referring to FIG. 8, a transparent conductive film P6 includes a conductive part having a comb pattern. Referring to FIG. 9, a transparent conductive film P6 includes a conductive part having a cross pattern. Referring to FIG. 10, a transparent conductive film P7 includes a conductive part having a mesh pattern.

The transparent conductive films P3 to P7 may be formed such that the line width of the conductive part is 0.6, 1, 5, 10, or 30 µm depending on the conductivity of the conductive paste, and the pattern interval is 100, 200, 300, 400, or 500 µm, or 2 mm, depending on the translucency.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

### <Description of Symbols>

| | |
|---|---|
| 1: Transparent film | 2, 22: Pattern groove |
| 3, 23: Conductive paste | 10: Unwinder |
| 20: Plasma processing unit | 30, 230: Patterning unit |
| 40: Dispensing unit | 50: Drying unit |
| 60: Winder | |
| 100, 200: Transparent conductive film manufacturing apparatus | |
| P2, P3, P4, P5, P6, P7: Transparent conductive film W: Line width | |

## Claims

1. A transparent conductive film manufacturing method, comprising:
a first step of processing one surface of a transparent film with plasma to form a hydrophobic surface with minute nano-metric protrusions and grooves;
a second step of patterning a hydrophilic pattern groove on one surface of the transparent film;
a third step of dispensing a conductive paste onto the pattern groove of the transparent film; and
a fourth step of drying and hardening the conductive paste.

2. The method of claim 1, wherein
in the second step, the pattern groove is patterned using a laser head by a scribing method.

3. The method of one of claims 1 to 2, wherein
in the third step, the conductive paste is dispensed to the pattern groove using a dispenser by a drop method.

4. The method of one of claims 1 to 3, wherein
in the second step, the pattern groove is patterned using a roll imprinter by an imprinting method.

5. A transparent conductive film manufacturing apparatus, comprising:
an unwinder which supplies a transparent film;
a plasma processing unit which processes one surface of the transparent film which is supplied by the unwinder with plasma to form a hydrophobic surface with minute nano-metric protrusions and grooves;
a patterning unit which patterns a hydrophilic pattern groove on one surface of the transparent film which passes through the plasma processing unit;
a dispensing unit which dispenses the conductive paste to the pattern groove of the transparent film which passes through the patterning unit;
a drying unit which dries and hardens the conductive paste on the transparent film which passes through the dispensing unit; and
a winder which winds the transparent conductive film which is manufactured by passing through the drying unit.

6. The apparatus of claim 5, wherein:
the patterning unit is formed as one of a laser head and a roll imprinter.

7. A transparent conductive film, comprising:
a transparent film which includes a hydrophobic part which is formed with minut nano-metric protrusions and grooves on one surface thereof by plasma processing and a hydrophilic part which is formed between the hydrophobic parts as a pattern groove; and
a conductive part which is formed by a conductive paste which fills the pattern groove,
wherein a lowest limit value of a line width of the conductive part is 0.6 µm.

8. The transparent conductive film of claim 7, wherein
the lowest limit value of a line width of the conductive part is 5 µm.

9. The transparent conductive film of one of claims 7 to 8, wherein:
the transparent film is made of one of polyimide (PI), polyethylene terephthalate (PET), polyethylene naphthalate (PEN), and polycarbonate (PC), and
the conductive paste is one of Ag, Al, and a conductive polymer.

10. The transparent conductive film of claim 9, wherein:
a difference in a height between an upper edge of the protrusion and a bottom of the groove is 1 to 10 nm.

## Patentansprüche

1. Herstellungsverfahren für einen transparenten, leitfähigen Film, umfassend:
einen ersten Schritt zum Bearbeiten einer Oberfläche eines transparenten Films mit Plasma zum Bilden einer hydrophoben Oberfläche mit winzigen nanometrischen Vorsprüngen und Nuten;
einen zweiten Schritt des Musterns eines hydrophilen Musters auf die Oberfläche des transparenten Films;
einen dritten Schritt des Ausgebens einer leitfähigen Paste auf die Musternut des transparenten Films; und
einen vierten Schritt des Trocknens und Aushärtens der leitfähigen Paste.

2. Verfahren nach Anspruch 1, wobei
im zweiten Schritt die Musternut mithilfe eines Laserkopfes durch ein Ritzverfahren gemustert wird.

3. Verfahren nach einem der Ansprüche 1 bis 2, wobei
im dritten Schritt die leitfähige Paste mit einer Abgabevorrichtung mithilfe eines Tropfverfahrens an die Musternut ausgegeben wird.

4. Verfahren nach einem der Ansprüche 1 bis 3, wobei
im zweiten Schritt die Musternut mit einem Walzenpräger mithilfe eines Prägeverfahrens gemustert wird.

5. Herstellungsvorrichtung für einen transparenten, leitfähigen Film, umfassend:
eine Abwickelvorrichtung, die einen transparenten Film zuführt;
eine Plasmaverarbeitungseinheit, welche eine Oberfläche des transparenten Films verarbeitet, der von der Abwickelvorrichtung mit Plasma zum Bilden einer hydrophoben Oberfläche mit winzigen nanometrischen Vorsprüngen und Nuten zugeführt wird;
eine Mustereinheit, die eine hydrophile Musternut auf eine Oberfläche des transparenten Films mustert, der die Plasmaverarbeitungseinheit durchläuft;
eine Ausgabeeinheit, welche die leitfähige Paste an die Musternut des transparenten Films ausgibt, der die Mustereinheit durchläuft;
eine Trocknungseinheit, welche die leitfähige Paste auf dem transparenten Film trocknet und härtet, der die Ausgabeeinheit durchläuft; und
eine Aufwickelvorrichtung, die den transparenten leitfähigen Film aufwickelt, der durch Durchlaufen der Trocknungseinheit hergestellt wird.

6. Vorrichtung nach Anspruch 5, wobei:
die Mustereinheit entweder als Laserkopf oder Walzenpräger ausgebildet ist.

7. Transparenter, leitfähiger Film, umfassend:
einen transparenten Film, der einen hydrophoben Teil, der mit winzigen nanometrischen Vorsprüngen und Nuten auf der Oberfläche davon durch Plasmabearbeitung ausgebildet ist, und einen hydrophilen Teil, der zwischen den hydrophoben Teilen als Musternut ausgebildet ist, aufweist; und
ein leitfähiges Teil, das durch eine leitfähige Paste gebildet wird, welche die Musternut füllt,
wobei ein unterster Grenzwert einer Linienbreite der leitfähigen Paste 0,6 µm beträgt.

8. Transparenter leitfähiger Film nach Anspruch 7, wobei
der unterste Grenzwert einer Linienbreite der leitfähigen Paste 5 µm beträgt.

9. Transparenter, leitfähiger Film nach einem der Ansprüche 7 bis 8, wobei:
der transparente Film aus einem von Polyimid (PI), Polyethylenterephthalat (PET), Polyethylennaphthalat (PEN) und Polycarbonat (PC) hergestellt ist, und
die leitfähige Paste eines von Ag, Al oder ein leitfähiges Polymer ist.

10. Transparenter, leitfähiger Film nach Anspruch 9, wobei:
ein Höhenunterschied zwischen einem oberen Rand des Vorsprungs und einer Unterseite der Nut 1 bis 10 nm beträgt.

## Revendications

1. Procédé de fabrication de film conducteur transparent, comprenant :
une première étape consistant à traiter une surface d'un film transparent avec du plasma pour former une surface hydrophobe avec des saillies et des rainures nanométriques minuscules ;
une deuxième étape consistant à former une rainure de motif hydrophile sur une surface du film transparent ;
une troisième étape consistant à distribuer une pâte conductrice sur la rainure de motif du film transparent ; et
une quatrième étape consistant à sécher et à durcir la pâte conductrice.

2. Procédé de la revendication 1, dans lequel, dans la deuxième étape, la rainure de motif est formée en utilisant une tête laser par un procédé de rainurage.

3. Procédé de l'une des revendications 1 et 2, dans lequel, dans la troisième étape, la pâte conductrice est distribuée à la rainure de motif en utilisant un distributeur par un procédé de dépôt.

4. Procédé de l'une des revendications 1 et 3, dans lequel, dans la deuxième étape, la rainure de motif est formée en utilisant un dispositif d'impression à rouleau par un procédé d'impression.

5. Appareil de fabrication de film conducteur transparent, comprenant :
un dérouleur qui fournit un film transparent ;
une unité de traitement au plasma qui traite une surface du film transparent qui est fourni par le dérouleur avec du plasma pour former une surface hydrophobe avec des saillies et des rainures nanométriques minuscules ;
une unité de formation de motif qui forme une rainure de motif hydrophile sur une surface du film transparent qui passe à travers l'unité de traitement au plasma ;
une unité de distribution qui distribue la pâte conductrice à la rainure de motif du film transparent qui passe à travers l'unité de formation de motif ;
une unité de séchage qui sèche et durcit la pâte conductrice sur le film transparent qui passe à travers l'unité de distribution ; et
un enrouleur qui enroule le film conducteur transparent qui est fabriqué en passant à travers l'unité de séchage.

6. Appareil de la revendication 5, dans lequel :
l'unité de formation de motif est formée en tant que l'un(e) parmi une tête laser et un dispositif d'impression à rouleau.

7. Film conducteur transparent comprenant :
un film transparent qui comporte une partie hydrophobe qui est formée avec des saillies et des rainures nanométriques minuscules sur une surface de celle-ci par un traitement au plasma et une partie hydrophile qui est formée entre les parties hydrophobes en tant que rainure de motif ; et
une partie conductrice qui est formée par une pâte conductrice qui remplit la rainure de motif,
dans lequel une valeur limite la plus basse d'une largeur de ligne de la partie conductrice est de 0,6 µm.

8. Film conducteur transparent de la revendication 7, dans lequel la valeur limite la plus basse d'une largeur de ligne de la partie conductrice est de 5 µm.

9. Film conducteur transparent de l'une des revendications 7 et 8, dans lequel :
le film transparent est réalisé en l'un parmi le polyimide (PI), le polyéthylène téréphtalate (PET), le polyéthylène naphtalate (PEN) et le polycarbonate (PC), et
la pâte conductrice est l'un parmi Ag, Al, et un polymère conducteur.

10. Film conducteur transparent de la revendication 9, dans lequel :
une différence de hauteur entre un bord supérieur de la saillie et un fond de la rainure est comprise entre 1 et 10 nm.
